# EUROPÄISCHE PATENTSCHRIFT

(11) **EP 1 289 876 B1**
(45) Veröffentlichungstag und Bekanntmachung des Hinweises auf die Patenterteilung: **16.01.2008**
(21) Anmeldenummer: 01951392.8
(22) Anmeldetag: 13.06.2001
(51) Int. Cl.: B81B 3/00, B81C 1/00

(54) **MIKROSTRUKTUR UND VERFAHREN ZU DEREN HERSTELLUNG**
MICROSTRUCTURE AND METHOD FOR THE PRODUCTION THEREOF
MICROSTRUCTURE ET SON PROCEDE DE PRODUCTION

(30) Priorität: 13.06.2000 DE 10029012
(43) Veröffentlichungstag der Anmeldung: 12.03.2003
(73) Patentinhaber: memsfab GmbH, 9125 Chemnitz (DE)
(72) Erfinder: BERTZ, Andreas, 09123 Chemnitz/Klaffenbach (DE); GESSNER, Thomas, 09113 Chemnitz (DE); KÜCHLER, Matthias, 09112 Chemnitz (DE); KNÖFLER, Roman, 09355 Gersdorf (DE)
(74) Vertreter: Rumrich, Gabriele
(86) Internationale Anmeldenummer: PCT/DE2001/002237
(87) Internationale Veröffentlichungsnummer: WO 2001/096232

(56) Entgegenhaltungen:
- EP-A- 0 747 686
- WO-A-95/10770
- US-A- 4 580 439
- US-A- 5 129 983
- US-A- 5 846 849
- PETERSEN K E: "MICROMECHANICAL LIGHT DEFLECTOR ARRAY" IBM TECHNICAL DISCLOSURE BULLETIN, IBM CORP. NEW YORK, US, Bd. 20, Nr. 1, 1. Juni 1977 (1977-06-01), Seiten 355-356, XP002015961 ISSN: 0018-8689

## Beschreibung

Die Erfindung betrifft eine Mikrostruktur und ein Verfahren zu deren Herstellung nach den Oberbegriffen des 1. und 20. Patentanspruchs.

Mikrostrukturen sind auf Basis der in der Halbleitertechnologie verbreiteten Silizium-Wafer sehr gut auch als miniaturisierte Sensoren und Aktoren herstell- und einsetzbar. Für mechanische Anwendungen ist es dabei im allgemeinen notwendig, daß mechanisch bewegliche Teile gefertigt werden, welche über definierte Federteile und Befestigungsanker mit einem Substrat verbunden sind. Die Befestigung der mechanisch beweglichen Teile soll dabei möglichst starr und zuverlässig erfolgen, während die Federteile eine vorgegebene Beweglichkeit der Mikrostrukturen zulassen. Zur Herstellung solcher Mikrostrukturen wurden in der Vergangenheit hauptsächlich Technologien eingesetzt, welche den Silizium-Wafer über die gesamte Waferdicke nutzen. Diese als Bulk-Mikromechanik bezeichnete Technologie ist im allgemeinen durch die Verwendung von mindestens 3 Wafern und anisotropen Naßätzprozessen gekennzeichnet. Im Sinne einer weiteren Miniaturisierung und Kostenreduktion setzen sich gegenwärtig aber immer mehr solche Technologien durch, welche nur den oberflächennahen oder den Oberflächenbereich des Silizium-Wafers nutzen. Letztere Technologie basiert üblicherweise auf der Abscheidung zusätzlicher Schichten, wovon eine später als Funktionsschicht für die mikromechanischen Komponenten dient, während eine weitere Schicht nur als sogenannte Opferschicht verwendet wird und nach deren Entfernung mittels Ätzen die mikromechanischen Komponenten in der Funktionsschicht freigibt. Obwohl diese Technologie zum Teil bereits mit Erfolg in die Produktion eingeführt wurde, sind besonders auch die mechanischen Eigenschaften der Funktiönsschichten für viele Anwendungen nicht so vorteilhaft, wie die von einkristallinem Silizium. Besonders im Hinblick auf die Federteile sind hier vor allem die praktische Ermüdungsfreiheit, Schichtspannungsfreiheit und hohe Bruchfestigkeit zu nennen. Aus diesem Grund wird zum Teil die Funktionsschicht durch einkristallines Silizium eines zweiten Wafers ersetzt, welcher zuvor mittels einer Wafer-Verbindungstechnik über eine Isolatorschicht mit dem Trägerwafer verbunden ist. Bei einem solchen als SOI-Wafer bezeichneten Verbund bestehen allerdings sehr hohe Anforderungen an die Verbindungstechnik und das Zurückschleifen des zweiten Wafers auf eine geringe Restdicke. Deshalb wurden Alternativlösungen entwickelt, bei denen die mikromechanischen Komponenten aus dem oberflächennahen Bereich eines Silizium-Wafers herausgelöst werden und die so zumindest im Kern auch aus einkristallinem Silizium bestehen. Dies wird beispielsweise in der WO 91/03074 beschrieben, wobei durch eine Folge anisotroper und isotroper Ätzschritte in Verbindung mit einer Passivierungsschicht Strukturen im Silizium oberflächennah freigelegt werden können. Allerdings werden dabei keinerlei Lösungen zur Realisierung der elektrischen Kontakte, der Isolation zum Substrat bzw. zu anderen Strukturen sowie zur mechanischen Befestigung angegeben. Hingegen wird in der US 5,846,849 das Metallisieren sowohl der Oberfläche als auch der Seitenflächen der freigelegten und an diesen Stellen mit einer Isolationsschicht versehenen Strukturen vorgeschlagen. Über diese Metallschicht kann die elektrische Potentialführung zur Ansteuerung der Mikrostruktur oder der Nachweis einer Potentialänderung eines elektrischen Meßsignales, beispielsweise infolge einer mechanischen Bewegung, erfolgen. Die Potentialtrennung erfolgt dabei durch Isolationsgräben um alle Elemente dieser Struktur herum, einschließlich der Bondinseln. Dieser relativ einfache und dabei kostengünstige Prozeßablauf hat aber zwei wesentliche Nachteile für die Anwendbarkeit der damit hergestellten mikromechanischen Komponenten zur Folge. So werden durch die Existenz von zusätzlich auf dem Silizium aufgebrachten Isolations- und Metallschichten mechanische Schichtspannungen eingebaut, welche zum Verziehen der Mikrostrukturen in vertikaler oder horizontaler Richtung führen können. Auch wird damit im Zusammenhang (Sridhar, U. et al.: Single Crystal Silicon Microstructures using Trench Isolation. Proceedings of the Transducers 99, Sendai, Japan, S. 258-261) eine hohe Anfälligkeit solcher Strukturen gegenüber Temperaturschwankungen angegeben. Weiterhin ist, bedingt durch die große Oberfläche der Siliziumstrukturen, welche über eine Isolationsschicht mit Metall bedeckt ist, die unerwünschte Parasitärkapazität zwischen Metall und Silizium-Substrat sehr hoch. Dies ist vor allem deshalb besonders kritisch, da der Einsatz der Mikrostrukturen für sensorische und aktorische Anwendungen bevorzugt an die Verwendung von Wechselspannungen im kHz-Bereich gebunden ist.

Die bisher beschriebenen Nachteile werden entsprechend der US 5,930,595 weitgehend vermieden, indem mit einem ersten Schritt die Befestigungsanker an drei Seiten und dem Boden vom Silizium-Substrat gelöst werden. Danach erfolgt eine Auffüllung der Isolationsabstände mit einem Isolationsmaterial und schließlich werden die Sensorstrukturen an der vierten, nicht isolierten Seite der Befestigungsanker definiert, und wiederum vom Silizium-Substrat gelöst. Da die entstehenden Strukturen im Silizium sehr schmal bzw. perforiert sind, stellt dies sehr hohe Anforderungen an die Zuordnungsgenauigkeit der Sensorstrukturen zu den freigelegten Strukturen der Befestigungsanker. Das Herauslösen muß, ähnlich wie in der WO 91/03074 beschrieben, hier doppelt erfolgen. Daher liegt der Hauptnachteil dieser Verfahrensweise in dem sehr hohen technischen Aufwand, verbunden mit einer Verringerung der Ausbeute. Hinzu kommt, daß die Auffüllung der Isolationsgräben bevorzugt zumindest teilweise durch thermische Oxidation erreicht wird, was einer Integration mit integrierten elektronischen Schaltkreisen im Wege steht.

Weitere bekannte Mikrostrukturen aus einkristallinem Silizium weisen leitfähige Verbindungen der Mikrostruktur zum Substrat auf, die durch Brücken (DE 199 28 291) bzw. Stege (DE 195 40 120) gebildet werden. In beiden Fällen verbleibt jedoch ein Teil der Mikrostruktur aus einkristallinem Silizium in Verbindung mit dem Substrat und bildet so eine mechanische Fixierung der Mikrostruktur und zugleich auch eine Unterbrechung der allseitigen Isolation.
In der WO 99/36941 wird zwar eine allseitige elektrische Isolation der Mikrostrukturen erreicht. Allerdings sind hier unter den leitfähigen Brücken mit Isolationsmaterial gefüllte Gräben vorgesehen, die eine mechanische Fixierung der ansonsten vollständig von Isolationsspalten umgebenden Mikrostruktur bilden.

Der Erfindung liegt die Aufgabe zugrunde, das Verfahren zur Herstellung der Mikrostrukturen wesentlich zu vereinfachen und dabei unerwünschte Parasitärkapazitäten der Mikrostrukturen zu minimieren sowie unerwünschte Verformungen der Mikrostrukturen zu vermeiden und eine sichere Lagefixierung des Funktionselements bzw. des Befestigungsankers zu gewährleisten.
Diese Aufgabe wird mit den Merkmalen des 1. und 20. Patentanspruches gelöst. Vorteilhafte Weiterbildungen ergeben sich aus den Unteransprüchen.
Die Mikrostruktur besteht aus wenigstens einem in einem, vorzugsweise elektrisch leitfähigen Substrat, insbesondere aus einkristallinem dotieretem Silizium, angeordneten Funktionselement. Erfindungsgemäß ist das Funktionselement allseitig vom Substrat durch Isolationsspalte mechanisch und elektrisch getrennt und an wenigstens einer Position mit einer Struktur einer elektrisch leitfähigen Schicht verbunden und durch diese bezogen auf das Substrat lagefixiert. An dem Funktionselement kann wenigstes eine Elektrode ausgebildet sein. Das Funktionselement ist als Befestigungsanker ausgebildet, mit welchem über mindestens ein Federteil wenigstens ein, z.B. als Elektrode wirkendes, Masseteil verbunden ist.
In diesem Fall sind ebenfalls Befestigungsanker, Federelement und Masseteil durch Isolationsspalte von dem Substrat getrennt. Dabei befindet sich zwischen dem Substrat und den Seitenflächen des Funktionselements bzw. den Seitenflächen von Befestigungsanker, Federelement und Masseteil ein erster seitlicher Isolationsspalt und zwischen dem Substrat und der Grundfläche des Funktionselements bzw. von Befestigungsanker, Federelement und Masseteil ein zweiter Isolationsspalt. Diese Isolationsspalte um Befestigungsanker, Federteil und Masseteil gehen dabei ineinander über und sind vorzugsweise mit Gas gefüllt oder evakuiert. Im einfachsten Fall sind die Isolationsspalte mit Luft gefüllt.
Das Funktionselement (der Befestigungsanker) ist an mindestens einer Position mit einer den ersten seitlichen Isolationsspalt überragenden ersten Struktur einer elektrisch leitfähigen Schicht (Kontaktierung) verbunden und durch diese bezogen auf das Substrat lagefixiert. Als elektrisch leitfähige Schicht wird dabei vorzugsweise eine Metallschicht, insbesondere aus Aluminium, verwendet.
Die erste Struktur der elektrisch leitfähigen Schicht, welche den ersten seitlichen Isolationsspalt zwischen den vom Substrat isolierten Funktionselement und der vom Substrat durch die Isolationsschicht isolierten zweiten Struktur der elektrisch leitfähigen Schicht überbrückt, ist zumindest über den Bereichen der Isolationsspalte als perforierte oder geschlitzte Struktur ausgeführt. Diese kann beispielsweise in Form einer Vielzahl von sehr schmalen Bahnen, bevorzugt mit Bahnbreiten unter 1 µm, ausgeführt werden. Anstelle einer einfachen elektrisch leitfähigen Schicht (ersten Struktur) zur Überbrückung der Isolationsspalte kann auch ein Schichtstapel, bestehend aus zumindest einer elektrisch leitfähigen Schicht und zumindest einer Isolationsschicht, Anwendung finden.
Die zwischen Substrat und elektrisch leitfähiger Schicht angeordnete Isolationsschicht besteht vorzugsweise aus einem Oxid oder Nitrid oder auch einer Oxinitridschicht.
Die Kontaktierung der elektrisch leitfähigen Schicht erfolgt vorzugsweise über periphere Anschlüsse.
Als Substrat wird bevorzugt Silizium mit einem spezifischen elektrischen Widerstand von weniger als 0,1 Ωcm verwendet.

Das Verfahren zur Herstellung der Mikrostruktur in einem vorzugsweise elektrisch leitfähigen Substrat, insbesondere aus einkristallinem dotiertem Silizium, mit wenigstens einem Funktionselement erfolgt dadurch, daß das Funktionselement so aus dem Substrat herausgelöst wird, daß zum Substrat allseitig Isolationsspalte vorhanden sind, und daß eine elektrisch leitfähige Schicht derart aufgebracht wird, daß sie mit dem Funktionselement verbunden ist und dieses sicher lagefixiert.
Zum Herauslösen des Flinktionselements aus dem Substrat werden vorzugsweise folgende Verfahrensschritte durchgeführt:
- Erzeugen einer Isolationsschicht auf dem Substrat mit Öffnungen durch Strukturieren in den Bereichen, welche das Funktionselement und die späteren umlaufenden ersten seitlichen Isolationsspalte zwischen dem Substrat und dem Funktionselement definieren,
- Aufbringen der elektrisch leitfähigen Schicht auf die Isolationsschicht und auf den nicht mit einer Isolationsschicht versehenen Bereich, welcher das Funktionselement bilden wird und gleichzeitig oder anschließend,
- Strukturieren der elektrisch leitfähigen Schicht derart, daß an mindestens einer Position eine Verbindung einer ersten Struktur der elektrisch leitfähigen Schicht zu dem zu erzeugenden Funktionselement bestehen bleibt, die über den späteren ersten seitlichen Isolationsspalt zwischen Substrat und Funktionselement reicht und Ausbildung einer mit der ersten Struktur in Verbindung stehenden zweiten Struktur der elektrisch leitfähigen Schicht sowie bedarfsweise einer Leitbahnstruktur auf dem mit der Isolationsschicht versehenen Substrat,
- vollständiges elektrisches und mechanisches Trennen des Funktionselements vom Substrat durch eine Folge von Ätzprozessen in Verbindung mit mindestens einem Passivierungsschritt, so daß die Isolationsspalte gebildet werden, wobei die durch die erste Struktur der elektrisch leitfähigen Schicht erzeugte Verbindung mit dem
- Funktionselement an mindestens einer Position brückenartig bestehen bleibt, so daß das Funktionselement durch diese sicher lagefixiert ist.

Bei Ausbildung des Befestigungsanker wird ein an diesem ausgebildetes Federteil und Masseteil gleichzeitig mit Herauslösen des Befestigungsankers von dem Substrat vollständig elektrisch und mechanisch getrennt.

Die vertikalen Bereiche, die beim Ätzen nicht entfernt werden sollen, sind mit einer Passivierungsschicht zu versehen.

Die Isolationsschicht wird durch thermische Oxidation von Silizium oder chemische Dampfphasenabscheidung hergestellt.

Zum vollständigen elektrischen und mechanischen Trennen von Befestigungsanker, Federteil und Masseteil vom Substrat, mit Ausnahme der mechanischen Fixierung des Befestigungsankers durch die erste Struktur der elektrisch leitfähigen Schicht, werden folgende Prozesse ausgeführt:
- Ätzen von Vertiefungen in das Substrat, zur Bildung der ersten seitlichen Isolationsspalte, mit einer fotolithografisch hergestellten Maske gleichzeitig zu der durch die Maskierungswirkung der strukturierten Oberflächenschichten erzeugten Maske,
- Aufbringen einer Passivierungsschicht an vertikalen und -horizontalen Flächen der ersten seitlichen Isolationsspalte,
- Ätzen der Passivierungsschicht zum Zwecke deren Entfernung zumindest am Boden des ersten seitlichen Isolationsspaltes, Unterätzen des Substratmaterials unter den an den Seitenflächen sowie der Oberfläche geschützten Mikrostrukturen zur Erzeugung des zweiten Isolationsspaltes zwischen Substrat und Boden von Funktionselement oder Befestigungsanker, Federteil und Masseteil.

Das Ätzen der Vertiefungen in das Substrat erfolgt dabei bevorzugt senkrecht zur Substratoberfläche mittels reaktiver Ionenätzprozesse. Parallel oder nachträglich zum bevorzugten senkrechten Ätzen, bezogen auf die Substratoberfläche mittels reaktiver Ionenätzprozesse in das Substrat, erfolgt ein definiertes isotropes Ätzen des Substratmaterials zur vollständigen elektrischen Isolation des Substrates von der elektrisch leitfähigen Schicht.

zum Ätzen der Vertiefungen (zur Bildung der Isolationsspalte) werden fluor- und kohlenstoffhaltige Gase oder alternativ chlorhaltige oder fluorhaltige Gase eingesetzt.
Nach dem isotropen Ätzen, entweder durch Trockenätzprozesse oder unter Verwendung naßchemischer Ätzlösungen, wird die Passivierungsschicht (z.B. ein Plasmapolymer) vollständig von der Oberfläche der elektrisch leitfähigen Schicht z.B. mittels Trockenätzprozesses, entfernt.
Die Kontaktierung der elektrisch leitfähigen Schicht erfolgt meist durch nachträgliches Anbringen peripherer Anschlüsse. Die peripheren Anschlüsse können aber andererseits auch bereits im umgebenden Substrat vorhanden sein.

Mit dem erfindungsgemäßen Verfahren wird der Herstellungsprozeß wesentlich vereinfacht und eine Mikrostruktur mit nur geringen parasitären Kapazitäten erzeugt. Insbesondere wird durch die konsequente Anwendung selbstjustierender Prinzipien erreicht, daß das Herauslösen der Mikrostrukturen aus dem Substratmaterial parallel zum Herauslösen der Befestigungsanker erfolgt. Dies bedeutet, daß mehrere Ätzschritte und zumindest ein Abscheideprozeß zur Passivierung eingespart werden können, was gleichzeitig einer Ausbeuteerhöhung entspricht. Darüber hinaus werden die Mikrostrukturen und deren Befestigungsanker im gleichen Lithografieschritt definiert. Deshalb können zwischen diesen beiden keinerlei Fehljustierungen auftreten, was die Funktionsweise und Zuverlässigkeit der Mikrostrukturen verbessert. Da die Isolation zwischen dem Befestigungsanker und dem Substrat an den Seitenflächen und am Strukturboden im wesentlichen mittels Luft- bzw. Vakuumspalt erreicht wird, ist die darüber wirkende unerwünschte Kapazität bereits durch die kleinere Dielektrizitätskonstante auf ca. ein Viertel gegenüber der Verwendung einer SiO₂-Schicht reduziert. Außerdem können die Abstände zwischen dem Befestigungsanker und dem Substrat vergrößert werden, da eine Auffüllung mit einem Isolationsmaterial entfällt, was aus wirtschaftlichen Gründen nur bis zu Spaltbreiten von wenigen Mikrometern praktikabel ist. Auf eine Oxidation zur Isolation bzw. elektrischen Trennung von Befestigungsanker und Substrat kann generell verzichtet werden. Während somit metallfreie bewegliche Strukturen hergestellt und genutzt werden können, wird auch die Entfernung der Passivierungsschicht, ohne Einsatz von Naßprozessen möglich. Letztere können insbesondere durch die Wirkung von Kapillarkräften zu unerwünschtem Verkleben von Strukturen führen. Damit wird eine funktionsfähige Mikrostruktur vorgeschlagen, welche letztlich nicht durch Schichtspannungen in ihrer Funktionalität beeinträchtigt wird.

Das erfindungsgemäße Verfahren kann beispielsweise auf einen Silizium-Wafer mit bereits vorhandenen Strukturen, z.B. einem integrierten Schaltkreis, oder auf einen blanken Silizium-Wafer angewendet werden. In beiden Fällen ist, falls nicht schon vorhanden, der Silizium-Wafer oberflächlich mit einem Isolator zu Versehen. Allenfalls können im zuerst genannten Fall Kontaktöffnungen ohne Isolationsschicht existieren. Diese Isolationsschicht ist erfindungsgemäß an den Stellen zu entfernen, an denen im nachfolgenden Prozeßablauf die Mikrostrukturen, mit deren Befestigungsanker und die ersten seitlichen Isolationsspalte entstehen sollen.
Diese gezielte Schichtentfernung kann mittels an sich bekannten Lithographie- und Ätzprozessen erfolgen. Anschließend folgt die Aufbringung einer elektrisch leitfähigen Schicht und deren Strukturierung. Die elektrisch leitfähige Schicht kann aus einem Metall, wie z.B. Aluminium, bestehen. Bei dieser Strukturierung, wiederum auf der Basis von an sich bekannten Lithographie- und Ätzprozessen, werden die Flächen, welche später als Befestigungsanker dienen, mittels Leitbahnen elektrisch kontaktiert. Die andere Seite der Leitbahnen wird entweder bis auf die schon auf dem Wafer vorhandenen elektrischen Kontaktflächen geführt oder zur Bildung von äußeren Kontaktflächen, beispielsweise sogenannten Bondinseln, genutzt. Zu beachten ist dabei, daß die Leitbahnen an den Stellen, welche nachfolgend die Isolationsgräben der Befestigungsanker bilden, perforiert bzw. sehr schmal gestaltet werden, um später möglichst wenig Silizium unter diesen Bahnen durch Ätzen entfernen zu müssen. An diese Schritte schließt sich das Ätzen von Silizium in Tiefen von beispielsweise 20 µm, das Passivieren mit einer Passivierungsschicht und letztlich das Freilegen der Mikrostrukturen und deren Befestigungsanker an. Bei den Ätzschritten darf dabei insbesondere die Metallschicht nicht wesentlich angegriffen werden, da ansonsten die nicht von Lack geschützten ersten Bereiche (Kontaktfinger) dieser elektrisch leitfähigen Schicht beschädigt bzw. abgetragen werden können. Die beim Ätzen von Silizium in die Tiefe des Funktionselements entstehenden Öffnungen ergeben somit die ersten seitlichen Isolationsspalte bzw. gegebenenfalls auch die in vielen Anwendungsfällen wichtigen, da als Kondensatorelektroden wirkenden, Seitenflächen sowie die für ein effektives Freilegen notwendige Perforation der Mikrostrukturen mit den Befestigungsankern. Sollte dabei ein streng gerichteter Ätzprozeß eingesetzt werden, bleibt das Silizium unter den Kontaktfingern erhalten und muß nachträglich durch isotropes Ätzen lateral entfernt werden. Bei einer ersten Struktur der elektrisch leitfähigen Schicht in Form von Kontaktfingern mit einer Breite von beispielsweise 0,8 µm beträgt demzufolge der notwendige laterale Abtrag mindestens 0,4 µm. Die dabei auftretende Verringerung der Breite der Mikrostrukturen kann durch ein Vorhaltemaß für die Mikrostrukturen berücksichtigt werden. Dabei werden die Einzelelemente der Mikrostruktur um mindestens 0,4 µm pro Kante breiter entworfen, als die gewünschte Strukturbreite nach deren Fertigstellung. Das gilt auch, wenn ein Verfahren zum Ätzen von Silizium genutzt wird, bei dem parallel zum Ätzen in die Tiefe ein laterales Ätzen um mindestens den gewünschten Betrag erfolgt. Eine Ausnahme bilden nur jene Ätzverfahren, bei welchen allein unter den nicht mit Photolack bedeckten Bereichen, also beispielsweise unter den metallischen Kontaktfingern, der laterale Abtrag erfolgt. In diesen Fällen muß für alle mit Photolack maskierten Mikrostrukturen kein zusätzliches Vorhaltemaß berücksichtigt werden.
Gemäß einem besonders günstigen Ausführungsbeispiel besteht die Passivierungsschicht aus einem organischen Polymer, welches Kohlenstoff sowie Fluor enthält und unter. Plasmaeinwirkung gebildet wird. Diese Polymerschicht kann nach dem Freilegen der Mikrostrukturen bevorzugt mittels plasmaaktiviertem Sauerstoff entfernt werden. Damit entfallen einerseits Naßprozesse und andererseits bestehen die Mikrostrukturen letztendlich nur noch aus Silizium. Des weiteren kann es zweckmäßig sein, vor der Lackmaskierung, zum Ätzen von Silizium in die Tiefe, noch eine zusätzliche Passivierungsschicht aufzubringen, welche auch über diese Maske geätzt wird und beim späteren isotropen Ätzen von Silizium den seitlichen Angriff des Ätzmittels an der Außenlinie der Berührungsfläche zwischen erster Struktur der elektrisch leitfähigen Schicht (z.B. Kontaktfinger) und der Oberseite von Funktionselement bzw. Befestigungsanker vermeidet.

Je nach Einsatzgebiet der Mikrostrukturen sollte das Silizium-Substrat ausreichend hoch dotiert sein bzw. auch während oder nach der hier dargestellten Prozeßfolge diese Dotierung erhalten. Für viele Anwendungen sind 10¹⁷ Dotierungsatome pro cm³ ausreichend.

Die Erfindung wird nachfolgend anhand eines Ausführungsbeispiels und zugehöriger Zeichnungen näher erläutert.

Es zeigen:
- Fig. 1:: Substrat 1 mit aufgebrachter und strukturierter Isolationsschicht 3,
- Fig. 2:: Substrat 1 mit bereits strukturierter elektrisch leitfähiger Schicht S,
- Fig. 3:: Substrat 1 mit Lackhaftmaske 6 zur Ausbildung des Funktionselements,
- Fig. 4:: Substrat 1 mit herausgeätzten senktechten Vertiefungen,
- Fig. 5:: Substrat 1 mit unter den Kontaktfingern 4a herausgelöstem Silizium,
- Fig. 6:: Mikrostruktur mit einem durch Unterätzen aus dem Substrat 1 herausgelösten Funktionselement 2.1,
- Fig. 7:: Mikrostruktur mit einem Funktionselement in Form eines Befestigungsankers 2.2 sowie mit einem über ein Federteil 7 daran befestigtem Masseteil 8,
- Fig. 8:: Schnitt A-A gem. Fig. 7.

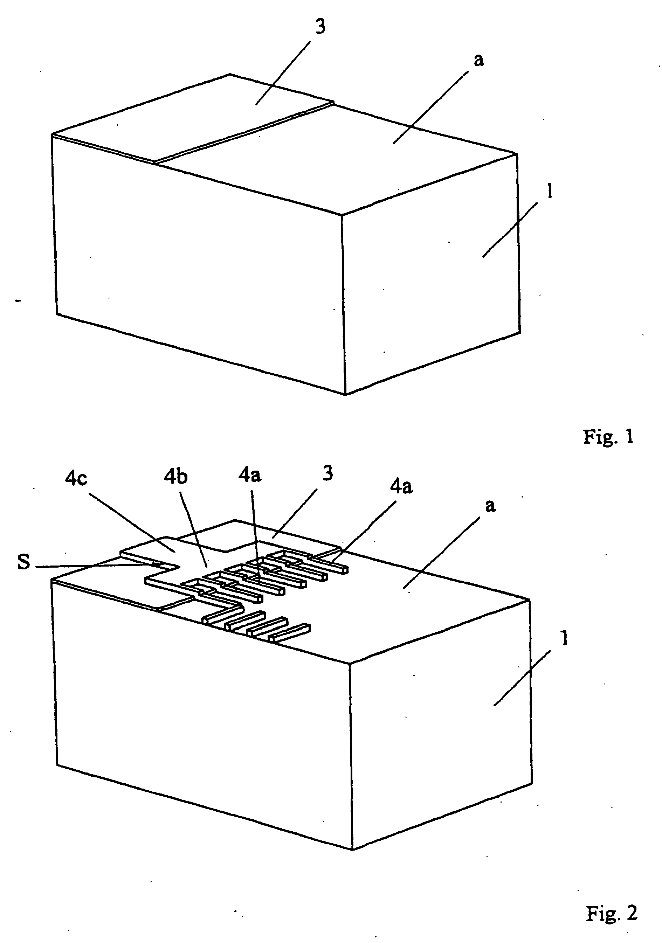

In Fig. 1 bis 6 werden die einzelnen Schritte zur Herstellung einer Mikrostruktur mit einem in einem Substrat 1 in Form eines Silizium-Wafers ausgebildeten Funktionselement 2.1 dargestellt. Das Substrat 1 weist beispielsweise einen spezifischen elektrischen Widerstand von 0,1 Ωcm und einen Durchmesser von 150 mm auf und wird zunächst durch thermische Oxidation ganzflächig und somit auf seiner Oberfläche a mit Siliziumdioxid SiO₂ als Isolationsschicht 3 mit einer Dicke von 300 nm versehen. Wie in Fig. 1 dargestellt, wird diese Isolationsschicht 3 in dem Bereich des Substrats 1 entfernt, welcher für das Funktionselement 2.1 vorgesehen ist. Dies geschieht vorteilhafter Weise mittels Photolithographie in Verbindung mit einem Plasmaätzprozeß und einer Plasmalackentfernung entsprechend dem Stand der Technik. Bei den nachfolgenden Schritten erfolgt zunächst die ganzflächige Abscheidung einer elektrisch leitfähigen Schicht S z.B. in Form einer Aluminiumschicht durch ein konventionelles Zerstäubungsverfahren mit einer Dicke von 800 nm. Diese elektrisch leitfähige Schicht S wird wiederum mittels Photolithographie mit einer nicht dargestellten Lackhaftmaske versehen, welche zu der vorhandenen Struktur in der Isolationsschicht 3 eine definierte Lage aufweist. Die durch reaktives Ionenätzen mit Hilfe der Maske in der elektrisch leitfähigen Schicht S entstehende Struktur bildet eine erste Struktur 4a, die mit der Oberfläche des späteren Funktionselements 2.1 verbunden ist, eine zweite Struktur 4b, die um den später das Funktionselement 2.1 umgebenden ersten seitlichen Isolationsspalt 5 führt und eine Leitbahnstruktur 4c für eine spätere Kontaktierung. Die erste Struktur 4a der elektrisch leitfähigen Schicht S ist dabei in Form von Kontaktfingern 4a ausgebildet, die jeweils eine Strukturbreite von z.B. 800 nm aufweisen und von der Länge her zum Teil auf der nicht mit einer Isolationsschicht versehenen Oberfläche a des Bereiches des Substrats 1 liegen, der später das Funktionselement bildet, wie in Figur 2 dargestellt. Auch hier schließt sich eine übliche Plasmalackentfernung an.

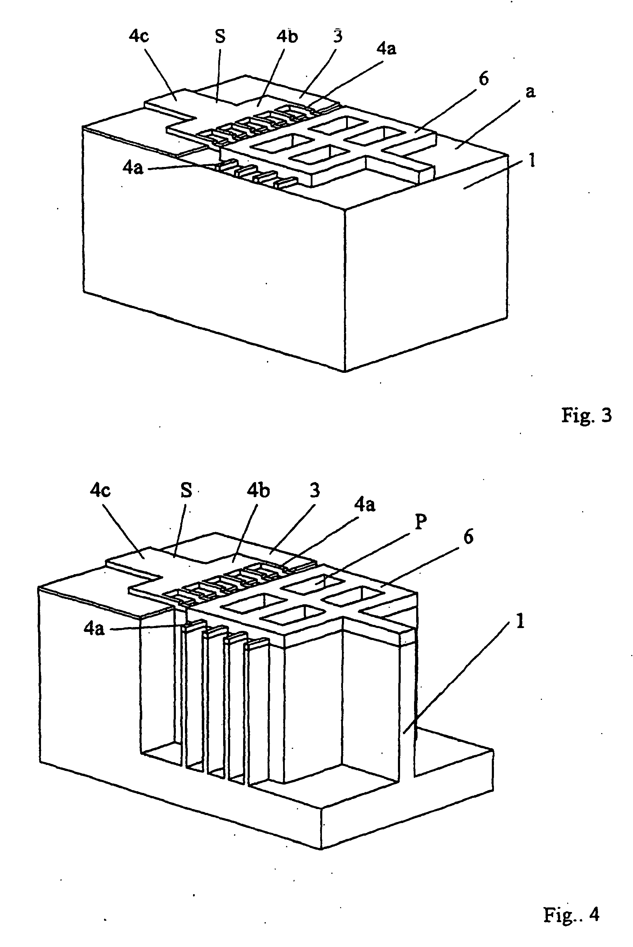

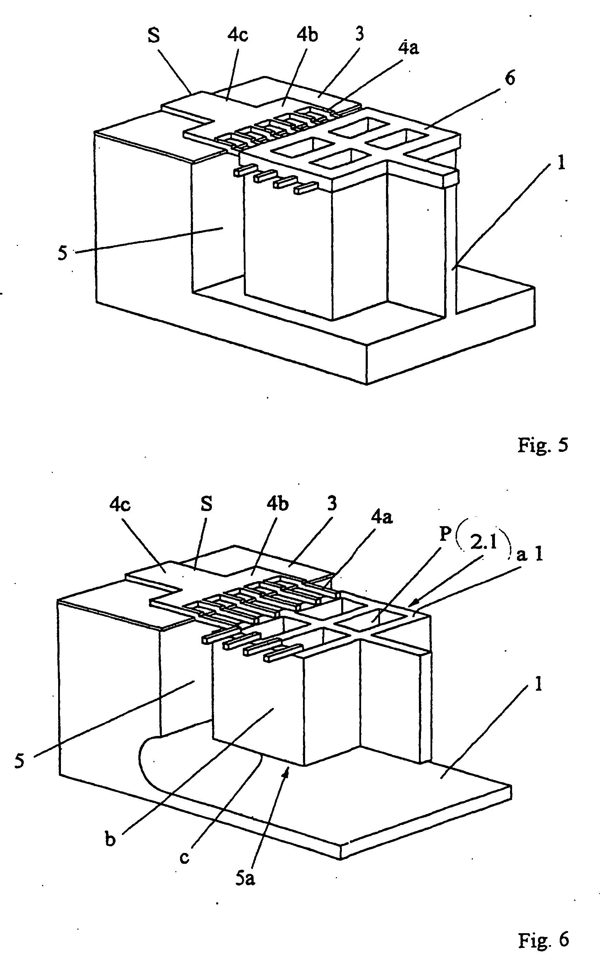

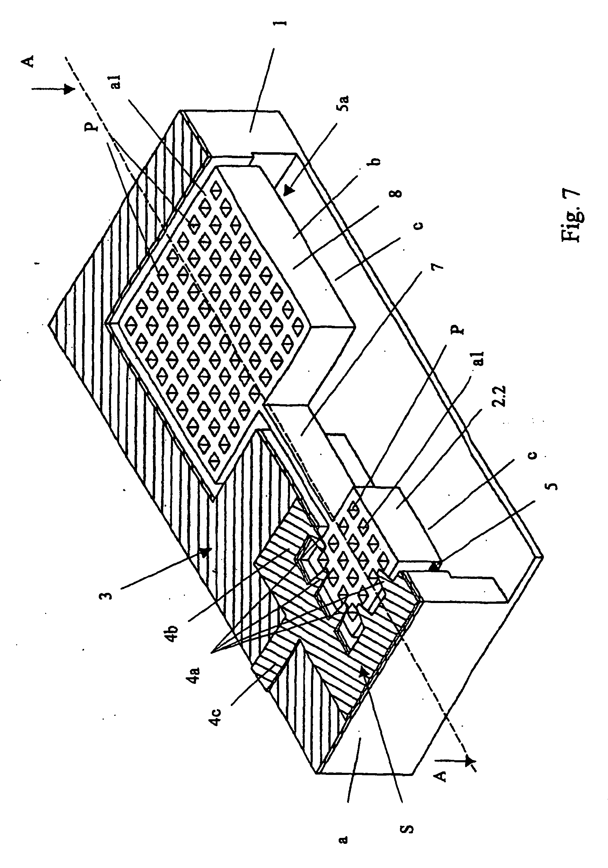

Im nachfolgenden Schritt gemäß Figur 3, wird mittels Photolithographie eine weitere Lackhaftmaske 6 aufgebracht, welche, gemeinsam mit der maskierend wirkenden elektrisch leitfähigen Schicht S, die Form sämtlicher in das Substrat 1 hinein zu ätzenden Strukturen definiert. Dazu gehört bei Ausbildung der Mikrostruktur gem. Fig. 7 beispielsweise auch das Federteil 7, das Masseteil 8 und auch der Befestigungsanker 2.2. Die Lage dieser Lackhaftmaske 6 ist auf die Lage der ersten Struktur 4a (hier als Kontaktfinger 4a) der elektrisch leitfähigen Schicht S so auszurichten, daß deren Enden möglichst alle gleichermaßen mit etwa 2 µm Länge mit Photolack bedeckt sind.
Das sich nun anschließende Silizium-Ätzen in eine Tiefe von ca. 20 µm ist in Figur 4 dargestellt und wird aus Selektivitätsgründen vorzugsweise mit Hilfe eines fluor-basierten alternierenden Atz- und Beschichtungsprozesses durchgeführt. Dieser an sich bekannte Ätzprozeß ermöglicht ein nahezu senkrechtes Ätzprofil. Es werden im wesentlichen die späteren ersten seitlichen Isolationsspalte 5 (s. Fig. 5) und eine Perforation, P im Funktionselement erzeugt. Dabei bleibt jedoch unter den Kontaktfingern 4a Siliziumsubstrat stehen, welches mit einem nachfolgenden isotropen Ätzen (Fig. 5) definiert entfernt wird, so daß nun die seitlichen Isolationsspalte 5 vollständig ausgebildet sind. Wie bereits erläutert, führt dieser isotrope Abtrag von mindestens 0,4 µm pro Strukturkante in diesem Ausführungsbeispiel auch zur Verringerung der Breite aller Mikrostrukturen.
Um definierte Endmaße für die Mikrostrukturen zu erhalten, muß demzufolge dieser nachträgliche Abtrag bereits beim Entwurf berücksichtigt werden.
In einem speziellen Ausführungsbeispiel kann das isotrope und anisotrope Ätzen in einem Schritt ausgeführt werden. So ist bekannt, daß beim Silizium-Ätzen auf Fluor-Basis gleichzeitig auch ein definierter lateraler Abtrag einstellbar ist. In einem besonders günstigen Ausführungsbeispiel ist dieser laterale Abtrag unter den nicht mit Photolack maskierten Bereichen, wie eben unter den Kontaktfingern 4a, besonders hoch. Dann kann die Berücksichtigung des lateralen Abtrags beim Entwurf verringert werden oder ganz entfallen. Auch hier wird der Photolack nach den Ätzprozessen wieder entfernt.
Es erfolgt nun die bekannte Freilegung des Funktionselements durch die Abscheidung einer nicht dargestellten als Passivierung wirkenden 750 nm dicken SiO₂-Schicht mit einem Plasma-CVD-Verfahren, einem anisotropen SiO₂-Ätzen zum öffnen der SiO₂-Schicht am Boden der ersten seitlichen Isolationsspalte 5 und der Perforierung P und einem isotropen Ätzen von Silizium auf der Basis eines fluor-basisten Ätzprozesses. Dabei ist zu beachten, daß bei dem hier beschriebenen Ausführungsbeispiel von einem hohen Aspektverhältnis der Öffnungen ausgegangen wird. D.h. die Ätztiefe ist ca. 10 mal größer als die Breite der Öffnungen. Dies hat den Vorteil, daß die SiO₂-Schicht am Boden der ersten Isolationsspalte 5 und der Perforation P nur ca. ein halb mal so dick ist wie an der Strukturoberfläche a. Dadurch wird erreicht, daß die SiO₂-Schicht nach dem anisotropen SiO₂-Ätzen zum Entfernen der SiO₂-Schicht am Boden des ersten seitlichen Isolationsspaltes 5 und der Perforation P geöffnet ist, während die Oberfläche a der Strukturen noch von einem Rest der Passivierungsschicht 6 bedeckt bleibt. Nach dem Freilegen und somit nach dem Erzeugen des zweiten Isolationsspaltes 5a (s. Fig. 6) unter der Grundfläche c des Funktionselements (2.1) wird das Restoxid zumindest von der Oberfläche der Mikrostruktur durch einen maskenlosen Ätzprozeß entfernt.
Den Teilschnitt der erzeugten Mikrostruktur mit einem über die Kontaktfinger 4a am Substrat 1 fixierten Funktionselement 2.1 zeigt Fig. 6. Das Funktionselement 2.1 weist zwischen seinen Seitenflächen b und dem Substrat 1 einen umlaufenden ersten seitlichen Isolationsspalt 5 und zwischen seinem Boden c und dem Substrat 1 einen zweiten Isolationsspalt 5a auf und ist somit vollständig vom Substrat 1 getrennt. Im Funktionselement 2.1 befindet sich weiterhin eine Perforation P, die zum Unterätzen erforderlich war. Die Kontaktfinger 4a der elektrisch leitfähigen Schicht S sind mit der Oberseite la des Funktionselements 2.1 verbunden, überbrücken den ersten seitlichen Isolationsspalt 5 und münden in die zweite Struktur 4b der elektrisch leitfähigen Schicht S, die auf der Isolationsschicht 3 angeordnet ist und den ersten seitlichen Isolationsspalt 5 umgibt. An die zweite Struktur 4b der elektrisch leitfähigen Schicht S schließt sich eine Leitbahnstruktur 4c an, die zur Kontaktierung dient. An dem Funktionselement 2.1 kann direkt eine Elektrode ausgebildet sein.
Die erfindungsgemäße Mikrostruktur zeigt überraschenderweise eine sehr hohe mechanische Stabilität sowie auch die erwartete hohe Planarität einschließlich sehr vorteilhafter elektrischer Eigenschaften. Für die erfindungsgemäßen Mikrostrukturen wurden Isolationswiderstände von über 10⁹ Ohm gemessen und die nachweisbare parasitäre Kapazität zum Substrat von ca. 5 pF war im wesentlichen auf die Kapazität zwischen den Bondflächen und dem Silizium-Substrat zurückzuführen.

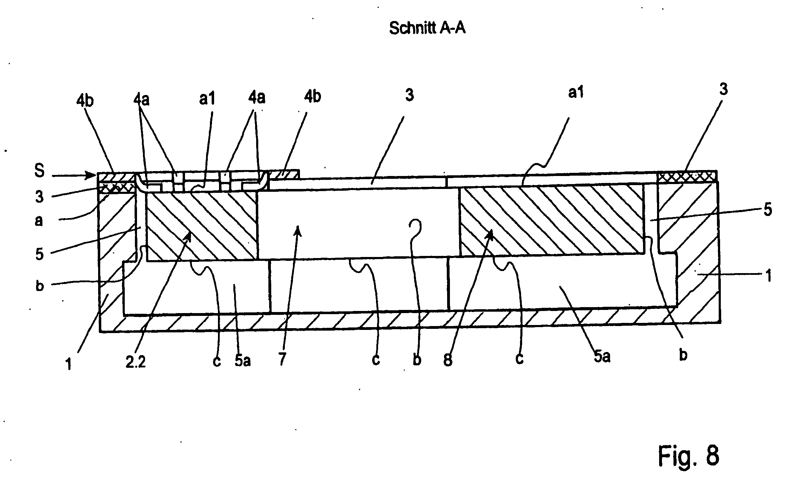

Figur 7 zeigt die dreidimensionale Ansicht und Fig. 8 den entsprechenden Längsschnitt A-A einer Mikrostruktur mit einem Funktionselement 2.1 in Form eines Befestigungsankers 2.2 und einem daran über ein Federteil 7 befestigten Masseteil 8. Im Substrat 1 wurden der Befestigungsanker 2.2, das Federteil 7 und das Masseteil 8 herausgelöst, so daß diese allseitig zum Substrat 1 beabstandet sind. Zwischen Substrat 1 und den Seitenwänden b von Befestigungsanker 2.2, Federteil 7 und Masseteil 8 ist ein erster umlaufender seitlicher Isolationsspalt 5 und zwischen Substrat 1 und den Grundflächen c von Befestigungsanker 2.2, Federteil 7 und Masseteil 8 ein zweiter Isolationsspalt 5a angeordnet. Auf der Oberfläche a des Substrats 1 befindet sich eine Isolationsschicht 3 und auf dieser wiederum eine strukturierte elektrisch leitfähige Schicht S. Die erste Struktur der elektrisch leitfähigen Schicht S ist in Form von Kontaktfingern 4a ausgebildet und mit der Oberseite al des aus Substratmaterial bestehenden Befestigungsankers 2.2 verbunden, so daß dieser Befestigungsanker 2.2 sicher lagefixiert ist. Die Kontaktfinger 4a reichen über den Isolationsspalt 5 zu einer zweiten Struktur 4b der elektrisch leitfähigen Schicht S, die den Befestigungsanker 2.2 umgibt. Die elektrisch leitfähige Schicht S verfügt weiterhin über eine Leitbahnstruktur 4c zur Kontaktierung. Zur Gewährleistung des ganzflächigen Unterätzens zur Bildung des zweiten Isolationsspaltes 5a verfügen Befestigungsanker 2.1 und Masseteil 8 über eine Perforation P.

Es besteht je nach Anwendungsfall, wie vorgenannt bereits beschrieben, auch die Möglichkeit, anstelle einer über ein Federteil 7 beweglichen Elektrode in Form des Masseteils 8, die Elektrode starr und direkt am Funktionselement 2.1 anzuordnen.
Gleichfalls kann das Federteil 7 auch das Masseteil 8 bilden. Entsprechend nicht dargestellter Ausfuhrungsbeispiele können am Befestigungsanker 2.2 auch mehrere gleichartig oder unterschiedlich ausgebildete Masseteile 8 über Federteile 7 angeordnet sein.

## Patentansprüche

1. Mikrostruktur, in einem vorzugsweise elektrisch leitfähigen Substrat (1), insbesondere aus einkristallinem dotiertem Silizium, mit wenigstens einem aus Substratataterial bestehendem Funktionselement wobei das Funktionselement als ein, zum Substrat (1) lagefixierter, Befestigungsanker (2.2) ausgebildet ist, an den sich wenigstens ein Federteil (7) anschließt, welches allseitig vom Substrat (1) durch Isolationsspalte (5, 5a) mechanisch und elektrisch getrennt ist, **dadurch gekennzeichnet, dass** der Befestigungsanker (2.2) ebenfalls allseitig vom Substrat (1) durch Isolationsspalte (5, 5a) mechanisch und elektrisch getrennt ist, wobei die Lagefixierung des Befestigungsankers (2.2) am Substrat (1) mit einer ersten Struktur (1a) einer elektrisch leitfähigen und von dem Substrat (1) elektrisch isolierten Schicht (s) erfolgt.

2. Mikrostruktur nach Anspruch 1, **dadurch gekennzeichnet, daß** mindestens eine Flache eines am Befestigungsanker (2.2) befestigten Funktionselementes (7, 8) als Elektrode ausgebildet ist.

3. Mikrostruktur nach Anspruch 1 oder 2, **dadurch gekennzeichnet, daß** mit dem Federteil (7) wenigstens ein Masseteil (8) verbunden ist, wobei das Masseteil (8) allseitig durch Isolationsspalte (5, 5a) mechanisch und elektrisch von dem Substrat (1) getrennt sind.

4. Mikrostruktur nach einem oder mehreren der Ansprüche 1 bis 3, **dadurch gekennzeichnet, daß** zwischen dem Substrat (1) und den Seitenflächen (b) des Befestigungsankere (2.2) ein erster seitlicher Isolationsspalt (5) und zwischen dem Substrat (1) und der Grundfläche (c) des Befestigungsankers (2.2) ein zweiter Isolationsspalt (5a) vorhanden ist.

5. Mikrostruktur nach einem oder mehreren der Ansprüche 1 bis 4, **dadurch gekennzeichnet, daß** die Isolationsspalte (5) und (5a) um Befestigungsanker (2.2), Federteil (7) und Masseteil (8) incinander übergehen.

6. Mikrostruktur nach einem oder mehreren der Ansprüche 1 bis 5, **dadurch gekennzeichnet, daß** die Isolationsspalte (5) und (5a) gasgefüllt oder evakuiert sind.

7. Mikrostruktur nach einem der Ansprüche 1 bis 6, **dadurch gekennzeichnet, daß** die mit dem Befestigungsanker (2.2) verbundene und diesen lagefixierende erste Struktur (4a) der elektrisch leitfähigen Schicht (S) den ersten seitlichen Isolationsspalt (5), der den Befestigungsanker (2.2) umgibt, wenigstens an einer Position überragt und auf eine, auf der Oberfläche (a) des Substrats (1) aufgebrachte, lsolationsschicht (3) führt.

8. Mikrostruktur nach einem oder mehreren der Ansprüche 1 bis 7, **dadurch gekennzeichnet, daß** die erste Struktur (4a) der elektrisch leitfähigen Schicht (S) an der Oberseite (a1) des Funktionselements (2.1) bzw. des Befestigungsankers (2.2) befestigt ist.

9. Mikrostruktur nach einem oder mehreren der Ansprüche 1 bis 8, **dadurch gekennzeichnet, daß** die erste Struktur (4a) der elektrisch leitfähigen Schicht (S) mit einer auf der Isolationsschicht (3) befindlichen zweiten Struktur (4b) der elektrisch leitfähigen Schicht (S) verbunden ist.

10. Mikrostruktur nach Anspruch 9, **dadurch gekennzeichnet, daß** die zweite Struktur (4b) der elektrisch leitfähigen Schicht (S) an den um das Funktionselement (2.1, 2.2) herumführenden ersten seitlichen Isolationsspalt (5) angrenzt und diesen vollständig oder teilweise umgibt und bedarfsweise in eine Leitbahnstruktur (4c) der elektrisch leitfähigen Schicht (S) mündet.

11. Mikrostruktur nach einem oder mehreren der Ansprüche 1 bis 10, **dadurch gekennzeichnet, daß** als elektrisch leitfähige Schicht (S) eine Metallschicht verwendet wird.

12. Mikrostruktur nach einem oder mehreren der Ansprüche 1 bis 11, **dadurch gekennzeichnet, daß** als elektrisch leitfähige Schicht (S) dotiertes polykristallines Silizium verwendet wird.

13. Mikrostruktur nach einem oder mehreren der Ansprüche 1 bis 12, **dadurch gekennzeichnet, daß** die erste Struktur (1a) der elektrisch leitfähigen Schicht (S) eine Perforation aufweist und/oder in Form einer Vielzahl von sehr schmalen Bahnen oder Kontaktfingern (4a) ausgebildet ist.

14. Mikrostruktur nach einem oder mehreren der Ansprüche 1 bis 13, **dadurch gekennzeichnet, daß** die Kontaktfinger (4a) eine Breite unter 1µm aufweisen.

15. Mikrostruktur nach einem oder mehreren der Ansprüche 1 bis 14, **dadurch gekennzeichnet, daß** die elektrisch leitfähige Schicht (S) mit peripheren Anschlüssen elektrisch kontaktiert ist.

16. Mikrostruktur nach einem oder mehreren der Ansprüche 1 bis 15, **dadurch gekennzeichnet, daß** die Isolationsschicht (3) aus einem Oxid, Nitrid oder einer Oxinitridschicht besteht.

17. Mikrostruktur nach einem oder mehreren der Ansprüche 1 bis 16, **dadurch gekennzeichnet, daß** als Substrat (1) Silizium mit einem spezifischen elektrischen Widerstand von weniger als 0,1 Ωcm verwendet wird.

18. Mikrostruktur nach einem oder mehreren der Ansprüche 1 bis 17, **dadurch gekennzeichnet, daß** die ersten seitlichen Isolationsspalte (5) zwischen dem vom Substrat (1) isolierten Befestigungsanker (2.2) und dem von der isolationsschicht (3) isolierten Substrat (1) durch einen Schichtstapel bestehend aus zumindest einer elektrisch leitfähigen Schicht und zumindest einer Isolationsschicht überbrückt werden.

19. Mikrostruktur nach einem oder mehreren der Ansprüche 1 bis. 18, **dadurch gekennzeichnet, daß** das Federteil (7) gleichzeitig die Funktion des Masseteils (8) wahrnimmt.

20. Verfahren zur Herstellung einer Mikrostruktur nach Anspruch 1, in einem vorzugsweise elektrisch leitfähigen Substrat (1), insbesondere aus einkristallinem dotiertem Silizium, mit wenigstens einem als Befestigungsanker (2.2) ausgebildeten und bezogen auf das Substrat lagefixierten Funktionselement, wobei sich an den Befestigungsanker ein allseitig vom Substrat getrenntes Federelement anschließt, **dadurch gekennzeichnet, dass** der Befestigungsanker (2.2) aus dem Substrat (1) herausgelöst wird, so daß zum Substrat (1) allseitig Isolationsspalte (5, 5a) vorhanden sind, und daß eine elektrisch leitfähige Schicht (S) derart aufgebracht wird, daß sie mit dem Befestigungsanker (2.2) verbunden ist und diesen lagefixiert.

21. Verfahren nach Anspruch 20, **dadurch gekennzeichnet, daß** folgende Verfahrensschritte durchgeführt werden:
- Erzeugen einer Isolationsschicht (3) auf der Oberfläche (a) des Substrats (1) mit Öffnungen durch Strukturieren in den Bereichen, welche den Befestigungsanker (2.2) und die späteren umlaufenden ersten scitlichen Isolationsspalte (5) zwischen dem Substrat (1) und dem Befestigungsanker (2.2) definieren,
- Aufbringen der elektrisch leitfähigen Schicht (S) auf der Isolationsschicht (3) und auf dem nicht mit einer Isolationsschicht (3) versehenen Bereich, welcher den Befestigungsanker (2.2) bilden wird und gleichzeitig oder anschließend,
- Strukturieren der elektrisch leitfähigen Schicht (S) derart, daß an mindestens einer Position eine Verbindung einer ersten Struktur (4a) der elektrisch leitfähigen Schicht (S) zu dem zu erzeugenden Befestigungsanker (2.2) bestehen bleibt, die über den späteren ersten seitlichen Isolationsspalt (5) zwischen Substrat (1) und Funktionselement (2.1, 2.2) reicht und Ausbildung einer mit der ersten Struktur (4a) in Verbindung stehenden zweiten Struktur (4b) der elektrisch leitfähigen Schicht (S), sowie bedarfsweise einer Leitbahnstruktur (4c) der elektrisch leitfähigen Schicht (8) auf dem mit der Isolationsschicht (3) versehenen Substrat (1),
- vollständiges elektrisches und mechanisches Trennen des Befestigungsankers (2.2) vom Substrat (1) durch eine Folge von Ätzprozessen in Verbindung mit mindestens einem Passivierungschritt, so daß die Isolationsspalte (5, 5a) gebildet werden, wobei die durch die erste Struktur (4a) der elektrisch leitfähigen Schicht (s) erzeugte Verbindung mit dem Befestigungsanker (2.2) an mindestens einer Position brückenartig bestehen bleibt, so daß der Befestigungsanker (2.2) durch diese sicher lagefixiert ist.

22. Verfahren nach Anspruch 20 oder 21, **dadurch gekennzeichnet, daß** das am Befestigungsanker (2.2) ausgebildete Federteil (7) sowie ein Masseteil (8) gleichzeitig mit Herauslösen des Befestigungsankers (2.2) von dem Substrat (1) vollständig elektrisch und mechanisch getrennt werden.

23. Verfahren nach einem oder mehreren der Ansprüche 20 bis 22, **dadurch gekennzeichnet, daß** zum vollständigen clektrischen und mechanischen Trennen von (2.2) und/oder Federteil (7) und/oder Masseteil (8) vom Substrat (1), mit Aufnahme der mechanischen Fixierung des Funktionselements (2.1) oder des Befestigungsankers (2.2) durch die erste Struktur (4a) der elektrisch leitfähigen Schicht (S), folgende Prozesse ausgeführt werden:
- Ätzen von Vertiefungen in das Substrat (1), zur Bildung der ersten seitlichen Isolationsspalte (5), mit einer fotolithografisch hergestellten Maske gleichzeitig zu der durch die Maskierungswirkung der strukturierten Oberflächenschichten entstandenen Maske,
- Aufbringen einer Passivierungsschicht an vertikalen und horizontalen Flächen der ersten seitlichen Isolationaspalte (5) ,
- Ätzen der Passivierungsschicht zum Zwecke deren Entfernung zumindest am Boden der ersten seitlichen Isolationsspalte (5), Unterätzen des Substratmaterials unter den an den Seitenflächen (b) sowie der Oberfläche (a) geschützten Bereichen des zu erzeugenden Funktionselements (2.1) bzw. Befestigungsankers (2.2) und bedarfsweise des Federteils (7) und/oder des Masseteils (8) zur Erzeugung des zweiten Isolationsspaltes (5a) zwischen Substrat (1) und Grundfläche (c) von Funktionselement (2.1) oder Befestigungsanker (2.2) und/oder Federteil (7) und/oder Masseteil (8).

24. Verfahren nach einem oder mehreren der Ansprüche 20 bis 23, **dadurch gekennzeichnet, daß** die Isolationsschicht (3) durch thermische Oxidation von Silizium oder durch chemische Dampfphasenabscheidung hergestellt wird.

25. Verfahren nach einem oder mehreren der Ansprüche 20 bis 24, **dadurch gekennzeichnet, daß** das Ätzen der Vertiefungen in das Substrat (1) bevorzugt senkrecht zur Substratoberfläche, zur Erzeugung des ersten seitlichen Isolationsspaltes (5), mittels reaktiver Ionenätzprozesse erfolgt.

26. Verfahren nach einem oder mehreren der Ansprüche 20 bis 25, **dadurch gekennzeichnet, daß** gleichzeitig oder im Anschluss zum senkrechten Ätzen, bezogen auf die Oberfläche (a) des Substrats (1), mittels reaktiver Ionenätzprozesse in das Substrat (1) ein definiertes isotropes Ätzen des Substratmaterials, zur vollständigen elektrischen Isolation des Substrates (1) von der elektrisch leitfähigen Schicht (S), erfolgt.

27. Verfahren nach einem oder mehreren der Ansprüche 20 bis 26, **dadurch gekennzeichnet, daß** fluor- und kohlenstoffhaltige Gase zum Ätzen der ersten seitlichen Isolationsspalte (5) in das Substrat (1) eingesetzt werden.

28. Verfahren nach einem oder mehreren der Ansprüche 20 bis 27, **dadurch gekennzeichnet, daß** chlorhaltige oder fluorhaltige Gase zum Ätzen der Isolationsspalte (5, 5a) in das Substrat (1) eingesetzt werden.

29. Verfahren nach einem oder mehreren der Ansprüche 20 bis 28, **dadurch gekennzeichnet, daß** Trockenätzprozesse und/oder naßchemische Ätzlösungen zum definierten isotropen Ätzen eingesetzt werden.

30. Verfahren nach einem oder mehreren der Ansprüche 20 bis 29, **dadurch gekennzeichnet, daß** nach dem Unterätzen des Substratmaterials die Passivierungsschicht vollständig von der Oberfläche der elektrisch leitfähigen Schicht (S) entfernt wird.

31. Verfahren nach einem oder mehreren der Ansprüche 20 bis 30, **dadurch gekennzeichnet, daß** die Passivierungsschicht aus einem organischen Material besteht, welches nach dem isotropen Ätzen vollständig von der Oberfläche der elektrisch leitfähigen Schicht mittels Trockenätzprozess entfernt wird.

32. Verfahren nach einem oder mehreren der Ansprüche 20 bis 30, **dadurch gekennzeichnet, daß** die Passivierungsschicht aus einem Plasmapolymer besteht.

33. Verfahren nach einem oder mehreren der Ansprüche 20 bis 32, **dadurch gekennzeichnet, daß** die elektrisch leitfähige Schicht (S) nachträglich durch periphere Anschlüsse elektrisch kontaktiert wird.

34. Verfahren nach einem oder mehreren der Ansprüche 20 bis 33, **dadurch gekennzeichnet, daß** die elektrisch leitfähige Schicht (s) durch periphere Anschlüsse, welche bereits im umgebenden Substrat (1) vorhanden sind, elektrisch kontaktiert wird.

35. Verfahren nach einem oder mehreren der Ansprüche 20 bis 34, **dadurch gekennzeichnet, daß** nach dem Aufbringen der elektrisch leitfähigen Schicht (S) und dem Strukturieren dieser Schicht eine zusätzliche zweite Passivierungsschicht aufgebracht wird, welche nachfolgend, unmittelbar vor dem Ätzen von Vertiefungen in das Substrat (1) mit gleicher Maske wie für das Ätzen der ersten seitlichen Isolationsspalte (5) in das Substrat (1), strukturiert wird.

36. Verfahren nach einem oder mehreren der Ansprüche 20 bis 35, **dadurch gekennzeichnet, daß** -die zusätzliche zweite Passivierungsschicht gemeinsam mit der Passivierungsschicht zumindest von der Oberfläche der elektrisch leitfähigen Schicht (S) entfernt wird.

## Claims

1. A microstructure, in a preferably electrically conductive substrate (1), particularly made of single-crystal doped silicon, having at least one functional element comprising substrate material, the functional element being implemented as a fastening anchor (2.2) fixed in position to the substrate (1), which at least one spring part (7) adjoins, which is mechanically and electrically separated on all sides from the substrate (1) by isolation gaps (5, 5a), **characterized in that** the fastening anchor (2.2) is also mechanically and electrically separated on all sides from the substrate (1) by isolation gaps (5, 5a), the position fixing of the fastening anchor (2.2) on the substrate (1) occurring using a first structure (4a) of an electrically conductive layer (S) which is electrically insulated from the substrate (1).

2. The microstructure according to Claim 1, **characterized in that** at least one face of a functional element (7, 8) fastened to the fastening anchor (2.2) is implemented as an electrode.

3. The microstructure according to Claim 1 or 2, **characterized in that** at least one ground part (8) is connected to the spring part (7), the ground part (8) being mechanically and electrically separated on all sides from the substrate (1) by isolation gaps (5, 5a).

4. The microstructure according to one or more of Claims 1 through 3, **characterized in that** a first lateral isolation gap (5) is provided between the substrate (1) and the lateral faces (b) of the fastening anchor (2.2) and a second isolation gap (5a) is provided between the substrate (1) and the base (c) of the fastening anchor (2.2).

5. The microstructure according to one or more of Claims 1 through 4, **characterized in that** the isolation gaps (5) and (5a) around the fastening anchor (2.2), spring part (7), and ground part (8) pass into one another.

6. The microstructure according to one or more of Claims 1 through 5, **characterized in that** the isolation gaps (5) and (5a) are gas-filled or evacuated.

7. The microstructure according to one or more of Claims 1 through 6, **characterized in that** the first structure (4a) of the electrically conductive layer (S), which is connected to the fastening anchor (2.2) and fixes it in position, projects beyond the first lateral isolation gap (5), which encloses the fastening anchor (2.2), on at least one position and leads to an insulation layer (3) applied to the surface (a) of the substrate (1).

8. The microstructure according to one or more of Claims 1 through 7, **characterized in that** the first structure (4a) of the electrically conductive layer (S) is fastened to the top side (a1) of the functional element (2.1) and/or the fastening anchor (2.2).

9. The microstructure according to one or more of Claims 1 through 8, **characterized in that** the first structure (4a) of the electrically conductive layer (S) is connected to a second structure (4b) of the electrically conductive layer (S) located on the insulation layer (3).

10. The microstructure according to Claim 9, **characterized in that** the second structure (4b) of the electrically conductive layer (S) adjoins the first lateral isolation gap (5) leading around the functional element (2.1, 2.2) and completely or partially encloses it and if needed opens into a printed conductor structure (4c) of the electrically conductive layer (S).

11. The microstructure according to one or more of Claims 1 through 10, **characterized in that** a metal layer is used as the electrically conductive layer (S).

12. The microstructure according to one or more of Claims 1 through 11, **characterized in that** doped polycrystalline silicon is used as the electrically conductive layer (S).

13. The microstructure according to one or more of Claims 1 through 12, **characterized in that** the first structure (4a) of the electrically conductive layer (S) has a perforation and/or is implemented in the form of multiple very narrow webs or contact fingers (4a).

14. The microstructure according to one or more of Claims 1 through 13, **characterized in that** the contact fingers (4a) have a width less than 1 µm.

15. The microstructure according to one or more of Claims 1 through 14, **characterized in that** the electrically conductive layer (S) is electrically contacted with peripheral terminals.

16. The microstructure according to one or more of Claims 1 through 15, **characterized in that** the insulation layer (3) comprises an oxide, nitride, or an oxinitride layer.

17. The microstructure according to one or more of Claims 1 through 16, **characterized in that** silicon having a specific electrical resistance of less than 0.1 Ωcm is used as the substrate (1).

18. The microstructure according to one or more of Claims 1 through 17, **characterized in that** the first lateral isolation gaps (5) between the fastening anchor (2.2) isolated from the substrate (1) and the substrate (1) isolated from the insulation layer (3) are bridged by a layer stack comprising at least one electrically conductive layer and at least one insulation layer.

19. The microstructure according to one or more of Claims 1 through 18, **characterized in that** the spring part (7) simultaneously assumes the function of the ground part (8).

20. A method for producing a microstructure according to Claim 1, in a preferably electrically conductive substrate (1), in particular made of single-crystal doped silicon, having at least one functional element, which is implemented as a fastening anchor (2.2) and is fixed in position in relation to the substrate, a spring element separated on all sides from the substrate adjoining the fastening anchor, **characterized in that** the fastening anchor (2.2) is dissolved out of the substrate (1), so that isolation gaps (5, 5a) are provided to the substrate (1) on all sides, and an electrically conductive layer (S) is applied in such a way that it is connected to the fastening anchor (2.2) and fixes it in position.

21. The method according to Claim 20, **characterized in that** the following method steps are performed:
- generating an insulation layer (3) on the surface (a) of the substrate (1) having openings by structuring in the areas which define the fastening anchor (2.2) and the later peripheral first lateral isolation gaps (5) between the substrate (1) and the fastening anchor (2.2),
- applying the electrically conductive layer (S) to the insulation layer (3) and to the area not provided with an insulation layer (3), which will form the fastening anchor (2.2), and simultaneously or subsequently,
- structuring the electrically conductive layer (S) in such a way that, on at least one position, a connection of a first structure (4a) of the electrically conductive layer (S) to the fastening anchor (2.2) to be generated remains in existence, which reaches over the later first lateral isolation gap (5) between substrate (1) and functional element (2.1, 2.2), and implementing a second structure (4b) of the electrically conductive layer (S), which is connected to the first structure (4a), as well as a printed conductor structure (4c) of the electrically conductive layer (S) on the substrate (1) provided with the insulation layer (3) if needed,
- completely electrically and mechanically separating the fastening anchor (2.2) from the substrate (1) by a sequence of etching processes in connection with at least one passivation step, so that the isolation gaps (5, 5a) are formed, the connection to the fastening anchor (2.2) generated by the first structure (4a) of the electrically conductive layer (S) remaining in existence like a bridge on at least one position, so that the fastening anchor (2.2) is securely fixed in position thereby.

22. The method according to Claim 20 or 21, **characterized in that** the spring part (7) implemented on the fastening anchor (2.2) and a ground part (8) are completely electrically and mechanically separated from the substrate (1) simultaneously with dissolving out the fastening anchor (2.2).

23. The method according to one or more of Claims 20 through 22, **characterized in that**, for the complete electrical and mechanical separation of (2.2) and/or spring part (7) and/or ground part (8) from the substrate (1), with the exception of the mechanical fixing of the functional element (2.1) or the fastening anchor (2.2) by the first structure (4a) of the electrically conductive layer (S), the following processes are executed:
- etching depressions in the substrate (1), to form the first lateral isolation gaps (5), using a mask produced by photolithography simultaneously with the mask arising by the masking action of the structured surface layers,
- applying a passivation layer on vertical and horizontal faces of the first lateral isolation gaps (5),
- etching the passivation layer for the purpose of its removal at least on the floor of the first lateral isolation gaps (5), undercutting the substrate material below the areas protected on the lateral faces (b) and the surface (a) of the functional element (2.1) and/or fastening anchor (2.2) to be generated and if needed the spring part (7) and/or the ground part (8) to generate the second isolation gap (5a) between substrate (1) and base (c) of functional element (2.1) or fastening anchor (2.2) and/or spring part (7) and/or ground part (8).

24. The method according to one or more of Claims 20 through 23, **characterized in that** the insulation layer (3) is produced by thermal oxidation of silicon or by chemical vapor-phase deposition.

25. The method according to one or more of Claims 20 through 24, **characterized in that** the etching of the depressions in the substrate (1) preferably occurs perpendicularly to the substrate surface, to generate the first lateral isolation gap (5), using reactive ion etching processes.

26. The method according to one or more of Claims 20 through 25, **characterized in that**, simultaneously or following the perpendicular etching, in relation to the surface (a) of the substrate (1), using reactive ion etching processes in the substrate (1), a defined isotropic etching of the substrate material is performed for complete electrical insulation of the substrate (1) from the electrically conductive layer (S).

27. The method according to one or more of Claims 20 through 26, **characterized in that** gases containing fluorine and carbon are used for etching the first lateral isolation gaps (5) in the substrate (1).

28. The method according to one or more of Claims 20 through 27, **characterized in that** gases containing fluorine or fluorine are used for etching the isolation gaps (5, 5a) in the substrate (1).

29. The method according to one or more of Claims 20 through 28, **characterized in that** dry etching processes and/or wet-chemical etching solutions are used for the defined isotropic etching.

30. The method according to one or more of Claims 20 through 29, **characterized in that** after the undercutting of the substrate material, the passivation layer is completely removed from the surface of the electrically conductive layer (S).

31. The method according to one or more of Claims 20 through 30, **characterized in that** the passivation layer comprises an organic material, which is completely removed from the surface of the electrically conductive layer using a dry etching process after the isotropic etching.

32. The method according to one or more of Claims 20 through 30, **characterized in that** the passivation layer comprises a plasma polymer.

33. The method according to one or more of Claims 20 through 32, **characterized in that** the electrically conductive layer (S) is subsequently electrically contacted by peripheral terminals.

34. The method according to one or more of Claims 20 through 33, **characterized in that** the electrically conductive layer (S) is electrically contacted by peripheral terminals which are already provided in the surrounding substrate (1).

35. The method according to one or more of Claims 20 through 34, **characterized in that**, after the application of the electrically conductive layer (S) and the structuring of this layer, an additional second passivation layer is applied, which is subsequently structured, immediately before the etching of depressions in the substrate (1), using the same mask as for the etching of the first lateral isolation gaps (5) in the substrate (1).

36. The method according to one or more of Claims 20 through 35, **characterized in that** the additional second passivation layer is removed jointly with the passivation layer at least from the surface of the electrically conductive layer (S).

## Revendications

1. Microstructure, dans un substrat (1) de préférence conducteur électrique, en particulier en silicium monocristallin dopé, avec au moins un élément fonctionnel composé du matériau du substrat, lequel élément fonctionnel est conçu comme un ancrage de fixation (2.2) fixé en position sur le substrat (1), auquel se raccorde au moins une partie de languette (7) qui est séparée de toutes parts mécaniquement et électriquement du substrat (1) par des intervalles d'isolation (5, 5a), **caractérisée en ce que** l'ancrage de fixation (2.2) est aussi séparé de toutes parts mécaniquement et électriquement du substrat (1) par des intervalles d'isolation (5, 5a), la fixation de la position de l'ancrage de fixation (2.2) sur le substrat (1) étant réalisée par une première structure (4a) d'une couche (S) conductrice électrique qui est isolée électriquement du substrat (1).

2. Microstructure selon la revendication 1, **caractérisée en ce qu'**une surface au moins d'un élément fonctionnel (7, 8) fixé sur l'ancrage de fixation (2.2) est conçue comme une électrode.

3. Microstructure selon la revendication 1 ou 2, **caractérisée en ce qu'**au moins une partie de masse (8) est reliée à la partie de languette (7), laquelle partie de masse (8) est séparée mécaniquement et électriquement du substrat (1) par des intervalles d'isolation (5, 5a).

4. Microstructure selon une ou plusieurs des revendications 1 à 3, **caractérisée en ce qu'**il existe entre le substrat (1) et les surfaces latérales (b) de l'ancrage de fixation (2.2) un premier intervalle d'isolation (5) et entre le substrat (1) et la surface de base (c) de l'ancrage de fixation (2.2) un deuxième intervalle d'isolation (5a).

5. Microstructure selon une ou plusieurs des revendications 1 à 4, **caractérisée en ce que** les intervalles d'isolation (5) et (5a) de l'ancrage de fixation (2.2), de la partie de languette (7) et de la partie de masse (8) se rejoignent les uns les autres.

6. Microstructure selon une ou plusieurs des revendications 1 à 5, **caractérisée en ce que** les intervalles d'isolation (5) et (5a) sont remplis de gaz ou bien un vide y est créé.

7. Microstructure selon une des revendications 1 à 6, **caractérisée en ce que** la première structure (4a) de la couche conductrice électrique (S) reliée à l'ancrage de fixation (2.2) et fixant la position de celui-ci dépasse au moins en un point le premier intervalle d'isolation latéral (5) qui entoure l'ancrage de fixation (2.2) et mène vers une couche isolante (3) appliquée sur la surface (a) du substrat (1).

8. Microstructure selon une ou plusieurs des revendications 1 à 7, **caractérisée en ce que** la première structure (4a) de la couche conductrice électrique (S) est fixée sur la face supérieure (a1) de l'élément fonctionnel (2.1) ou de l'ancrage de fixation (2.2).

9. Microstructure selon une ou plusieurs des revendications 1 à 8, **caractérisée en ce que** la première structure (4a) de la couche électriquement conductrice (S) est reliée à une deuxième structure (4b) de la couche électriquement conductrice (S) située sur la couche isolante (3).

10. Microstructure selon la revendication 9, **caractérisée en ce que** la deuxième structure (4b) de la couche électriquement conductrice (S) est limitrophe du premier intervalle d'isolation (5) faisant le tour de l'élément fonctionnel (2.1, 2.2) et entoure entièrement ou partiellement celui-ci et débouche si nécessaire dans une structure de pistes conductrices (4c) de la couche conductrice électrique (S).

11. Microstructure selon une ou plusieurs des revendications 1 à 10, **caractérisée en ce que** la couche conductrice électrique (S) utilisée est une couche métallique.

12. Microstructure selon une ou plusieurs des revendications 1 à 11, **caractérisée en ce que** la couche conductrice électrique (S) utilisée est faite de silicium polycristallin dopé.

13. Microstructure selon une ou plusieurs des revendications 1 à 12, **caractérisée en ce que** la première structure (4a) de la couche conductrice électrique (S) présente une perforation et/ou est conformée sous la forme d'une pluralité de pistes ou pattes de contact (4a) très étroites.

14. Microstructure selon une ou plusieurs des revendications 1 à 13, **caractérisée en ce que** les pattes de contact (4a) ont une largeur inférieure à 1 µm.

15. Microstructure selon une ou plusieurs des revendications 1 à 14, **caractérisée en ce que** la couche conductrice électrique (S) est mise en contact électrique avec des connexions périphériques.

16. Microstructure selon une ou plusieurs des revendications 1 à 15, **caractérisée en ce que** la couche isolante (3) se compose d'une couche d'oxyde, de nitrure ou d'oxyde et de nitrure.

17. Microstructure selon une ou plusieurs des revendications 1 à 16, **caractérisée en ce que** le substrat (1) est du silicium ayant une résistance électrique spécifique de moins de 0,1 Ωcm.

18. Microstructure selon une ou plusieurs des revendications 1 à 17, **caractérisée en ce que** les premiers intervalles d'isolation latéraux (5) sont franchis, entre l'ancrage de fixation (2.2) isolé du substrat (1) et le substrat (1) isolé de la couche d'isolation (3), par une pile de couches formée d'au moins une couche conductrice électrique et au moins une couche d'isolation.

19. Microstructure selon une ou plusieurs des revendications 1 à 18, **caractérisée en ce que** la partie de languette (7) assure en même temps la fonction de la partie de masse (8).

20. Procédé pour la fabrication d'une microstructure selon la revendication 1, dans un substrat (1) de préférence conducteur électrique, en particulier en silicium dopé monocristallin, avec au moins un élément fonctionnel conçu comme un ancrage de fixation (2.2) et fixé en position par rapport au substrat, dans lequel un élément de languette séparé de toutes parts du substrat se raccorde à l'ancrage de fixation, **caractérisé en ce que** l'ancrage de fixation (2.2) est détaché du substrat (1), de sorte qu'il existe des intervalles d'isolation (5, 5a) sur tous les côtés du substrat, et **en ce qu'**une couche conductrice électrique (S) est appliquée de telle manière qu'elle est reliée à l'ancrage de fixation (2.2) et fixe la position de celui-ci.

21. Procédé selon la revendication 20, **caractérisé en ce que** les étapes de procédé suivantes sont exécutées :
- création d'une couche isolante (3) sur la surface (a) du substrat (1) avec des ouvertures par structuration dans les zones qui définissent l'ancrage de fixation (2.2) et le premier intervalle d'isolation (5) qui sera plus tard circonférenciel entre le substrat (1) et l'ancrage de fixation (2.2),
- application de la couche conductrice électrique (S) sur la couche isolante (3) et sur la zone ne portant pas de couche isolante (3) qui va former l'ancrage de fixation (2.2), et simultanément ou ensuite,
- structuration de la couche conductrice électrique (S) de telle sorte qu'il reste dans au moins une position une liaison d'une première structure (4a) de la couche conductrice électrique (S) avec l'ancrage de fixation (2.2) à créer, qui s'étend par-dessus le futur premier intervalle d'isolation latéral (5) entre le substrat (1) et l'élément fonctionnel (2.1, 2.2), et formation d'une deuxième structure (4b) de la couche électriquement conductrice (S) reliée à cette première structure (4a), ainsi au besoin que d'une structure de pistes conductrices (4c) de la couche électriquement conductrice (S) sur le substrat (1) muni de la couche d'isolation (3),
- séparation électrique et mécanique complète de l'ancrage de fixation (2.2) et du substrat (1) par une succession de processus de gravure chimique en relation avec au moins une étape de passivation, de sorte que les intervalles d'isolation (5, 5a) sont formés, tandis que la liaison créée par la première structure (4a) de la couche électriquement conductrice (S) avec l'ancrage de fixation (2.2) subsiste en formant un pont dans au moins une position, de sorte que l'ancrage de fixation (2.2) est fixé en position par celle-ci.

22. Procédé selon la revendication 20 ou 21, **caractérisé en ce que** la partie de languette (7) formée sur l'ancrage de fixation (2.2) et une partie de masse (8) sont complètement séparées mécaniquement et électriquement du substrat (1) en même temps que l'ancrage de fixation (2.2) est détaché.

23. Procédé selon une ou plusieurs des revendications 20 à 22, **caractérisé en ce qu'**en vue de la séparation électrique et mécanique complète de l'ancrage de fixation (2.2) et/ou de la partie de languette (7) et/ou de la partie de masse (8) du substrat (1), à l'exception de la fixation mécanique de l'élément fonctionnel (2.1) ou de l'ancrage de fixation (2.2.) par la première structure (4a) de la couche électriquement conductrice (S), les opérations suivantes sont effectuées :
- gravure de creux dans le substrat (1) pour former le premier intervalle d'isolation latéral (5), à l'aide d'un masque fabriqué par photolithographie, en même temps que le masque obtenu par l'effet de masquage des couches de surface structurées,
- application d'une couche de passivation sur les surfaces verticales et horizontales du premier intervalle d'isolation latéral (5),
- gravure de la couche de passivation en vue d'enlever celle-ci au moins sur le fond du premier intervalle d'isolation latéral (5), attaque du matériau du substrat en dessous des zones protégées sur les surfaces latérales (b) et la surface (a) de l'élément fonctionnel (2.1) à créer ou de l'ancrage de fixation (2.2) et, si nécessaire, de la partie de languette (7) et/ou de la partie de masse (8) pour créer le deuxième intervalle d'isolation (5a) entre le substrat (1) et la surface de base (c) de l'élément fonctionnel (2.1) ou de l'ancrage de fixation (2.2) et/ou de la partie de languette (7) et/ou de la partie de masse (8).

24. Procédé selon une ou plusieurs des revendications 20 à 23, **caractérisé en ce que** la couche d'isolation (3) est fabriquée par oxydation thermique de silicium ou par déposition chimique en phase vapeur.

25. Procédé selon une ou plusieurs des revendications 20 à 24, **caractérisé en ce que** la gravure des creux dans le substrat (1) est effectuée de préférence perpendiculairement à la surface du substrat, pour produire le premier intervalle d'isolation latéral (5), au moyen de processus de gravure ionique réactive.

26. Procédé selon une ou plusieurs des revendications 20 à 25, **caractérisé en ce qu'**en même temps ou après la gravure verticale, par rapport à la surface (a) du substrat (1), par des processus de gravure ionique réactive, une gravure isotrope définie du matériau du substrat est réalisée dans le substrat (1) pour obtenir une isolation électrique complète du substrat (1) par rapport à la couche électriquement conductrice (S).

27. Procédé selon une ou plusieurs des revendications 20 à 26, **caractérisé en ce que** des gaz contenant du fluor et du carbone sont utilisés pour graver le premier intervalle d'isolation latéral (5) dans le substrat (1).

28. Procédé selon une ou plusieurs des revendications 20 à 27, **caractérisée en ce que** gaz contenant du fluor et du carbone sont utilisés pour graver les intervalles d'isolation (5, 5a) dans le substrat (1).

29. Procédé selon une ou plusieurs des revendications 20 à 28, **caractérisé en ce que** des procédés de gravure à sec et/ou des solutions chimiques de gravure par voie humide sont utilisées pour la gravure isotrope définie.

30. Procédé selon une ou plusieurs des revendications 20 à 29, **caractérisé en ce qu'**après l'attaque du matériau du substrat, la couche de passivation est complètement enlevée de la surface de la couche électriquement conductrice (S).

31. Procédé selon une ou plusieurs des revendications 20 à 30, **caractérisé en ce que** la couche de passivation se compose d'un matériau organique qui est complètement éliminé de la surface de la couche électriquement conductrice après la gravure isotrope au moyen d'un procédé de gravure à sec.

32. Procédé selon une ou plusieurs des revendications 20 à 30, **caractérisé en ce que** la couche de passivation se compose d'un polymère déposé par plasma.

33. Procédé selon une ou plusieurs des revendications 20 à 32, **caractérisé en ce que** la couche conductrice électrique (S) est ensuite mise en contact électrique par des connexions périphériques.

34. Procédé selon une ou plusieurs des revendications 20 à 33, **caractérisé en ce que** la couche conductrice électrique (S) est mise en contact électrique par des connexions électriques déjà présentes dans le substrat (1) environnant.

35. Procédé selon une ou plusieurs des revendications 20 à 34, **caractérisé en ce qu'**après l'application de la couche conductrice électrique (S) et la structuration de cette couche, une deuxième couche de passivation supplémentaire est appliquée, laquelle est ensuite structurée, immédiatement avant la gravure des creux dans le substrat (1), avec le même masque que celui servant à graver le premier intervalle d'isolation (5) dans le substrat (1).

36. Procédé selon une ou plusieurs des revendications 20 à 35, **caractérisé en ce que** la couche de passivation supplémentaire est enlevée en même temps que la couche de passivation, au moins de la surface de la couche électriquement conductrice (S).
